# FASCICULE DE BREVET EUROPEEN

(11) **EP 3 266 079 B1**
(45) Date de publication et mention de la délivrance du brevet: **08.07.2020**
(21) Numéro de dépôt: 15714583.0
(22) Date de dépôt: 06.03.2015
(51) Int. Cl.: H01S 5/02, H01S 5/32, H01S 5/227

(54) **LASER GERMANIUM SUR SILICIUM EN TECHNOLOGIE CMOS**
GERMANIUM-AUF-SILICIUM-LASER IN CMOS-TECHNOLOGIE
GERMANIUM-ON-SILICON LASER IN CMOS TECHNOLOGY

(43) Date de publication de la demande: 10.01.2018
(73) Titulaire: STMicroeletronics Crolles 2 SAS, 38920 Crolles (FR); Centre National de la Recherche Scientifique CNRS, 75794 Paris Cedex 16 (FR); Université Paris-Sud, 91405 Orsay Cedex (FR)
(72) Inventeur: PROST, Mathias, F-93290 Tremblay-En-Franc (FR); EL KURDI, Moustafa, 94230 Cachan (FR); BOUCAUD, Philippe, F-75013 Paris (FR); BOEUF, Frédéric, F-38420 Le Versoud (FR)
(74) Mandataire: Cabinet Beaumont
(86) Numéro de dépôt international: PCT/FR2015/050555
(87) Numéro de publication internationale: WO 2016/142588

(56) Documents cités:
- EP-A1- 0 673 061
- JP-A- S60 113 982
- JP-A- 2000 183 155
- JP-A- 2004 170 608
- US-A1- 2013 202 005
- TANI KAZUKI ET AL: "Germanium waveguides on lateral silicon-on-insulator diodes for monolithic light emitters and photo detectors", 10TH INTERNATIONAL CONFERENCE ON GROUP IV PHOTONICS, IEEE, 28 août 2013 (2013-08-28), pages 134-135, XP032513443, ISSN: 1949-2081, DOI: 10.1109/GROUP4.2013.6644407 [extrait le 2013-10-22]

## Description

### Domaine

La présente demande concerne un laser germanium réalisable sur silicium de façon compatible avec la réalisation de circuits intégrés CMOS.

### Exposé de l'art antérieur

Un laser germanium sur silicium est constitué d'une longueur désirée d'un guide d'onde comprenant une bande de germanium de type N enserrée entre des bandes de silicium de type P et du silicium de type N. Les bandes de silicium de type P et de type N doivent pouvoir être connectées à des potentiels respectivement positif et négatif ou nul de façon à réaliser une injection électrique planaire dans le germanium. Ce laser peut fonctionner à une longueur d'onde comprise dans une plage de longueurs d'onde de 1,55 à 2,2 µm, en fonction notamment du niveau de contrainte du germanium.

On décrira ici essentiellement la réalisation d'un guide d'onde silicium-germanium-silicium. On comprendra que, pour réaliser un laser, ce guide d'onde sera délimité longitudinalement à ses extrémités opposées par des surfaces réflectrices qui peuvent correspondre par exemple à des tranchées de façon à obtenir une interface air-germanium. On pourra préférer déposer une mince couche de nitrure de silicium, SiN, pour réaliser une interface air-SiN-germanium ou former un miroir de Bragg adapté à la longueur d'onde d'émission du laser que l'on veut réaliser. Ces diverses options permettent d'associer sur une puce photonique le laser germanium à un guide d'onde passif en silicium ou en SiN, en notant que le silicium est transparent dans l'infrarouge aux longueurs d'onde auxquelles fonctionne un laser germanium.

L'ensemble silicium-germanium-silicium forme une double hétérostructure. Le germanium dopé N est la zone active du laser. Les deux autres semiconducteurs jouent le rôle de barrières de potentiel qui permettent d'injecter et de confiner dans le germanium les porteurs nécessaires à la génération de recombinaisons radiatives. Typiquement la bande de germanium est dopée de type N avec une densité de 0,8 à 4.10¹⁹ atomes par cm³. Un tel ensemble est divulgué dans US20130202005 qui divulgue un guide d'onde germanium comprenant une bande de substrat de silicium de type P revêtue d'une bande de germanium dopée de type N et d'une bande dopée de type N.

Il existe un besoin pour un laser germanium fabricable en utilisant uniquement des technologies usuelles dans le domaine des circuits intégrés CMOS, et notamment des circuits intégrés CMOS sur silicium dans lesquels certains au moins des transistors ont des zones de canal en germanium ou en silicium-germanium contraint.

### Résumé

L'objet de l'invention est telle que définie dans les revendications annexées Ainsi, un mode de réalisation prévoit un procédé de formation d'un guide d'onde germanium comprenant les étapes consistant à délimiter une zone d'un substrat de silicium de type P par des tranchées, revêtir cette zone d'une bande de germanium fortement dopée du type N et d'une première bande de silicium dopée de type N ; et revêtir l'ensemble de la structure d'une couche de nitrure de silicium.

Selon un mode de réalisation, le procédé comprend l'étape consistant à définir dans le nitrure de silicium des ouvertures de contact sur les côtés de la première bande de silicium recouvrant la bande de germanium.

Selon un mode de réalisation, le procédé comprend, après la formation des tranchées et le revêtement de germanium et de silicium, une étape consistant à élargir les ouvertures dans le substrat de sorte que la bande de germanium repose sur un pied de silicium.

Un mode de réalisation prévoit un guide d'onde germanium comprenant une bande de substrat de silicium de type P délimitée par des tranchées latérales revêtue d'une bande de germanium fortement dopée de type N et d'une première bande de silicium dopée de type N, l'ensemble étant revêtu d'une couche de nitrure de silicium.

Selon un mode de réalisation, les tranchées sont élargies dans leur partie pénétrant dans le substrat de silicium, d'où il résulte que la bande de germanium repose sur une deuxième bande de silicium de largeur réduite.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A à 1D sont des vues en coupe transverse illustrant des étapes successives de fabrication d'un premier mode de réalisation d'un laser germanium ;
les figures 2A à 2E sont des vues en coupe transverse illustrant des étapes successives de fabrication d'une variante du premier mode de réalisation d'un laser germanium ;
les figures 3A à 3G sont des vues en coupe transverse illustrant des étapes successives de fabrication d'un exemple d'un laser germanium ;
les figures 4A à 4F sont des vues en coupe transverse illustrant des étapes successives de fabrication d'un exemple d'un laser germanium ; et
les figures 5A à 5E sont des vues en coupe transverse illustrant des étapes successives de fabrication d'un exemple d'un laser germanium.

### Description détaillée

De mêmes éléments ont été désignés par de mêmes références aux différentes figures et, de plus, les diverses figures ne sont pas tracées à l'échelle. Par souci de clarté, seuls les éléments qui sont utiles à la compréhension des modes de réalisation décrits ont été représentés et sont détaillés.

Dans la description qui suit, lorsque l'on fait référence à des qualificatifs de position tels que les termes "dessus", "dessous", "supérieur", "inférieur", etc., il est fait référence à la position des éléments concernés dans les figures.

### 1. Laser à injection planaire

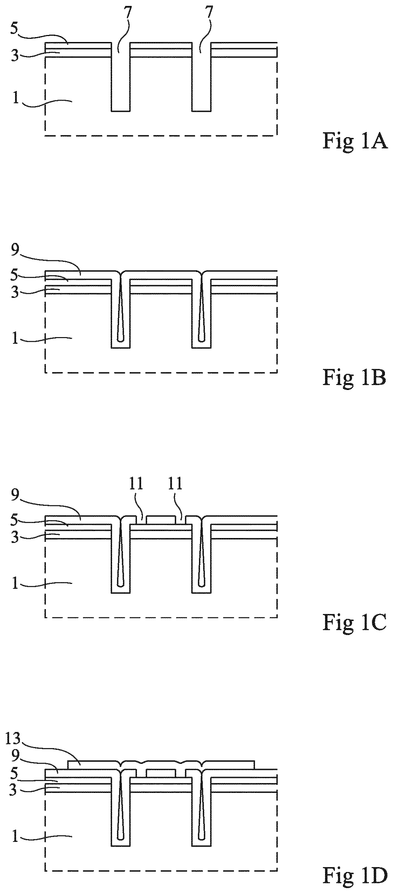

Les figures 1A à 1D sont des vues en coupe transverse illustrant des étapes successives de fabrication d'un premier mode de réalisation d'un laser germanium, à injection planaire.

Comme l'illustre la figure 1A, on part d'un substrat de silicium 1 de type P, qui peut être une couche mince de silicium sur isolant (SOI). Sur ce substrat 1, on dépose une couche mince de germanium 3 de type N qui est ensuite recouverte d'une couche mince de silicium 5 de type N. On notera que la couche 5 peut être une couche de silicium polycristallin, les matériaux des couches 1 et 3 étant monocristallins. Le guide d'onde est formé dans la partie centrale de la figure 1A délimitée par des tranchées 7 qui pénètrent dans le substrat 1 et s'étend orthogonalement au plan de la figure.

A une étape suivante illustrée en figure 1B, on dépose une couche de nitrure de silicium 9. De façon classique, le dépôt de la couche de nitrure de silicium est réalisé par dépôt chimique en phase vapeur assisté par plasma (PECVD) à une température comprise entre 300 et 700°C. La mise sous contrainte en tension du germanium est assurée par le fait que la couche de nitrure de silicium (SiN) est contrainte en compression lors de son dépôt. Cette contrainte va se relaxer et la couche de nitrure revient dans un état plus stable et s'étire. Cette déformation entraîne que les couches situées sous la couche de nitrure de silicium sont contraintes en tension. De préférence, le guide d'onde est orienté dans la direction cristallographique <100> du germanium. La couche de nitrure de silicium 9 recouvre la structure et, de préférence, pénètre dans les tranchées 7. Avant le dépôt de la couche de nitrure de silicium, il est possible de déposer une couche d'oxyde de silicium d'une dizaine de nanomètres d'épaisseur afin d'améliorer l'accroche et de passiver les surfaces libres des semiconducteurs.

A une étape suivante illustrée en figure 1C, on réalise des ouvertures 11 dans la couche de nitrure de silicium pour permettre de réaliser un contact sur la couche de silicium 5 sous-jacente. Comme cela est représenté, les ouvertures 11 sont de préférence disposées de part et d'autre de la largeur du guide pour éviter de relaxer la contrainte provoquée par la couche de nitrure de silicium 9 dans les couches sous-jacentes.

Après quoi, comme l'illustre la figure 1D, on dépose une couche d'un matériau conducteur 13 pour former des contacts sur la couche 5 de silicium de type N. En outre, un contact électrique non représenté est établi de façon classique sur le substrat 1 de silicium de type P. Ce contact peut être reporté latéralement dans une zone proche du guide d'onde. On peut par exemple déposer un ruban de métal parallèle au guide dans une zone gravée sur une profondeur proche d'une dizaine de micromètres pour réaliser le contact sur le substrat 1.

Selon le choix des matériaux utilisés et de la géométrie de la structure (largeur du guide, épaisseur des couches, profondeur des tranchées, position des ouvertures) et les caractéristiques de la couche de nitrure de silicium déposée par PECVD, la déformation uniaxiale dans le germanium induite par la couche de nitrure de silicium peut atteindre un niveau de 0,55 à 0,87 %. La structure présentée est adaptable à différents types d'empilements de matériaux.

La contrainte est appliquée sur toute la largeur du guide de manière homogène même pour des épaisseurs assez importantes de la couche de germanium. Ceci permet d'avoir un milieu actif de plusieurs centaines de micromètres de longueur, et par conséquent un gain linéique important pour le laser.

La largeur du guide d'onde peut être de 4 à 6 µm, selon les propriétés optiques souhaitées, tout en offrant un bon transfert de la contrainte.

L'épaisseur de la couche 3 de germanium dopé N est d'environ 250 à 300 nm (proche de λ/2n, où λ est la longueur d'onde d'émission du laser, et n est l'indice de réfraction du germanium). Cette épaisseur permet d'avoir un bon guidage de la lumière dans le domaine du proche infrarouge. La couche 5, qui sert d'injecteur électrique, doit être choisie avec une épaisseur suffisante pour obtenir un contact électrique de bonne qualité, mais pas trop épaisse pour éviter que cette couche n'absorbe la contrainte transmise par la couche de SiN.

À partir des impératifs énoncés ci-dessus, des simulations numériques par éléments finis du comportement mécanique de la structure peuvent être effectuées pour optimiser les différents paramètres de la topologie du guide d'onde (profondeur des tranchées, largeur du guide, positionnement des ouvertures). On peut simuler le transfert de la contrainte dans la structure à partir de la valeur de la contrainte initiale de la couche de nitrure de silicium déposée sur une épaisseur de 300 nm. La valeur de la contrainte hydrostatique initiale du film de SiN en compression est de -4,5 GPa (en pratique, on obtient -1,8 GPa dans le plan de la couche à l'équilibre). Le niveau de contrainte peut être modifié en modifiant les paramètres de dépôt de la couche de nitrure de silicium. Les valeurs de déformation uniaxiale ne prennent en compte que l'effet de la couche de SiN. Selon les conditions de dépôt de la couche de germanium sur silicium, il est possible d'obtenir une contrainte résiduelle initiale de type biaxiale liée à la différence de coefficient de dilatation thermique. Cette déformation qui est comprise entre 0,15 et 0,25 %, peut s'ajouter à la déformation totale qu'il est possible de transférer par la couche de nitrure de silicium.

La couche de nitrure de silicium déposée dans le fond des tranchées forme une poche de contrainte en compression. Cette poche est défavorable pour obtenir l'effet laser dans le germanium. Une gravure des tranchées à une profondeur de 1,5 µm donne un résultat optimal pour limiter cet effet, et ce pour différentes largeurs de guide pouvant aller jusqu'à 5 µm.

Des essais et simulations ont montré que les dimensions des éléments du guide d'onde devaient de préférence être situées dans les plages suivantes :
- largeur du guide : 4 à 6 µm,
- épaisseur de la couche 3 de germanium : 200 à 500 nm,
- épaisseur de la couche 5 d'injecteur : 100 à 250 nm,
- épaisseur de la couche 9 de nitrure : de 300 à 500 nm,
- largeur des tranchées : de 0,5 à 1 µm,
- profondeur des tranchées : de 1 à 1,5 µm,
- largeur des ouvertures : de 200 à 500 nm,
- distance des ouvertures aux bords : de 200 à 500 nm.

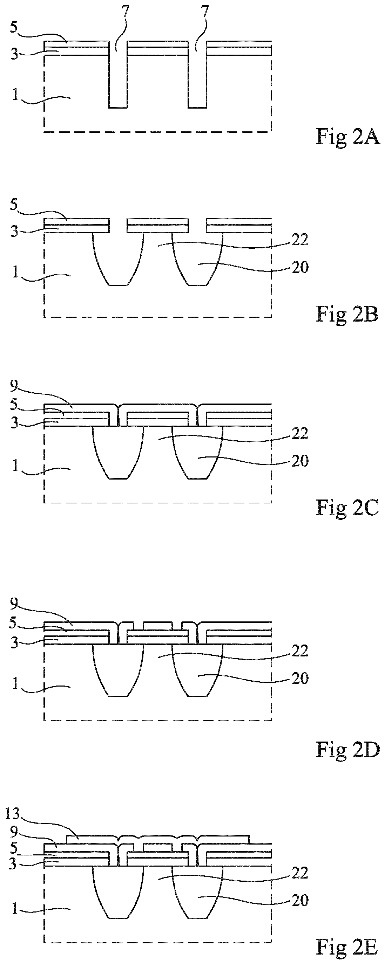

Les figures 2A à 2E sont des vues en coupe transverse illustrant des étapes successives de fabrication d'une variante de la structure de la figure 1D.

La figure 2A représente la structure déjà décrite en relation avec la figure 1A.

A une étape illustrée en figure 2B, on réalise une gravure isotrope sélective du silicium de type P 1 de sorte que les tranchées 7 s'élargissent sous la couche de germanium 3 pour former des ouvertures en cuvette 20. Ainsi, sous la bande de germanium 3, il demeure en place seulement une partie rétrécie ou pied 22 du substrat de silicium 1. Bien entendu, le pied 22 s'étend en une bande orthogonale au plan des figures.

Les étapes suivantes illustrées en figures 2C à 2E sont respectivement identiques aux étapes décrites en relation avec les figures 1B à 1D.

Ainsi, dans la structure de la figure 1D, le substrat de silicium 1 s'étend sous toute la portion de couche de germanium 3 alors que dans la structure de la figure 2E, la portion de couche de germanium ne repose qu'en partie sur un pied de silicium 22. La libération de la couche de germanium permet une déformation de plus grande amplitude et l'obtention d'un transfert de contrainte plus efficace.

La variante des figures 2A à 2E, dans laquelle le germanium est suspendu sur un pied, permet d'obtenir les avantages suivants par rapport au cas des figures 1A à 1D :
- contrainte plus importante dans la structure,
- confinement du mode optique au centre de la structure, et
- confinement des porteurs au centre de la structure lors de l'injection électrique.

Pour un guide de 5 µm de large sans pied, on peut obtenir une déformation uniaxiale en tension dans le germanium de 0,5 %. La sous-gravure permet d'amplifier cette valeur jusqu'à 0,75 %. Plus le pied est fin, plus la déformation atteignable dans la structure sera importante, mais le maximum est situé à l'interface entre la couche de SiN et le semiconducteur pour l'injection électrique. Cet effet est lié au cintrage de la structure. Un bon compromis est donné pour un ratio de 0,5 à 0,7, par exemple 0,6, entre la largeur du guide d'onde et la taille du pied.

Des essais et simulations ont montré que les dimensions des éléments du guide d'onde pouvaient de préférence être situées dans les plages suivantes :
- largeur du guide : 3 à 5 µm,
- hauteur du pied : 1 à 1,5 µm,
- largeur du pied : 0,55 à 0,65 fois la largeur de la bande de germanium,
- largeur des ouvertures : de 200 à 500 nm,
- distance des ouvertures aux bords : de 200 à 500 nm.

### 2. Premier exemple de laser à injection latérale

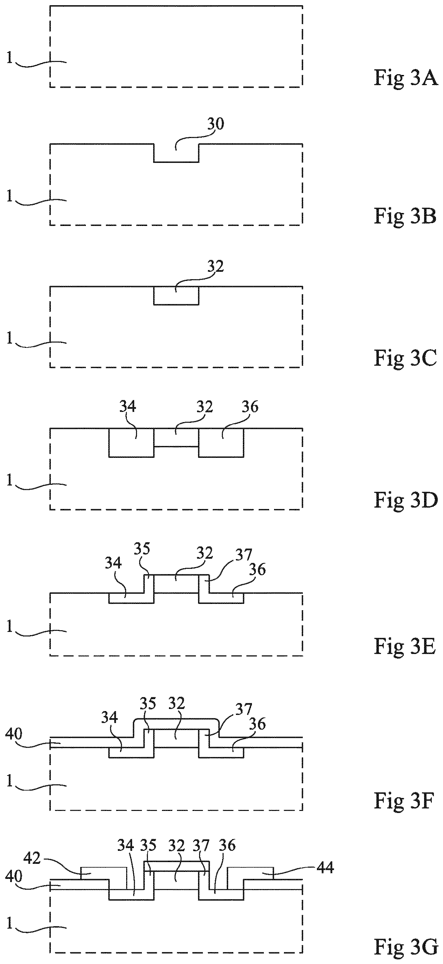

Les figures 3A à 3G sont vues en coupe transverses illustrant des étapes successives de fabrication d'un exemple d'un laser germanium, à injection latérale.

Comme l'illustre la figure 3A, on part d'un substrat 1 en silicium, éventuellement de type SOI. Ce substrat est de préférence faiblement dopé, et pratiquement isolant, ou dopé de type P.

A l'étape illustrée en figure 3B, on a formé une rainure 30 dans le substrat.

A l'étape illustrée en figure 3C, la rainure a été remplie par épitaxie localisée d'une bande 32 de germanium fortement dopé de type N.

A l'étape illustrée en figure 3D, on a formé dans le substrat 1, de part et d'autre de la bande de germanium 32, des bandes parallèles 34 et 36 dopées par implantation, respectivement de type P et de type N.

A l'étape illustrée en figure 3E, on a masqué la surface supérieure de la bande de germanium 32 et une partie voisine des bandes de silicium dopées parallèles 34 et 36. Après quoi on a procédé à une gravure de façon à former une zone en relief comprenant une partie haute 35 de la bande 34 et une partie haute 37 de la bande 36 qui encadrent la bande de germanium 32.

A l'étape illustrée en figure 3F, l'ensemble de la structure est revêtu d'une couche de nitrure de silicium 40 qui produit l'effet de contrainte souhaité comme cela a été décrit précédemment. On notera que, dans ce mode de réalisation, le nitrure est déposé directement sur le germanium et donc que la contrainte est appliquée directement à celui-ci et est donc encore plus efficace que dans les modes de réalisation décrits précédemment de guides à injection planaire. Avant le dépôt de la couche de nitrure de silicium, il est possible de déposer une couche d'oxyde de silicium d'une dizaine de nanomètres d'épaisseur afin d'améliorer l'accroche et de passiver les surfaces libres des semiconducteurs.

A l'étape illustrée en figure 3G, la couche de nitrure a été maintenue seulement sur la surface supérieure du guide et à l'extérieur de la structure. Après quoi on a formé des métallisations 42 et 44 en contact, respectivement, avec les bandes de silicium 34 et 36. La métallisation 42 est destinée à être connectée, en fonctionnement, à un potentiel positif et la métallisation 44 est destinée à être connectée, en fonctionnement, à un potentiel négatif ou nul.

Les couches latérales de silicium dopé permettent de reporter la prise des contacts latéralement par rapport au guide d'onde. Les contacts métalliques n'influent pas sur le transfert de la contrainte dans le germanium via la couche de nitrure de silicium. Cela permet aussi d'éviter la perturbation du mode optique par le métal, et d'éviter qu'un éventuel échauffement des conducteurs métalliques d'amenée de courant n'affecte la zone active du guide d'onde.

Pour un guide d'onde de 5 µm de large avec une zone active de 4,6 µm de large, la déformation atteint un niveau de 0,5 %. Les résultats sont proches d'un guide à injection planaire. Mais lorsque la largeur du guide est réduite à 2 µm, le rapport de forme entre la largeur du guide et celle de la couche de SiN est modifié, et la déformation uniaxiale peut atteindre un niveau de 1,3 %.

Des essais et simulations ont montré que les dimensions des éléments du guide d'onde pouvaient de préférence être situées dans les plages suivantes :
- largeur du guide : 1,6 à 3 µm,
- largeur de la couche de Ge : 1,5 à 2,5 µm,
- largeur des couches de Si : 2x200 nm,
- hauteur du guide: 300 nm à 1 µm,
- épaisseur de la couche de SiN : 300 à 500 nm.

### 3. Deuxième exemple de laser à injection latérale

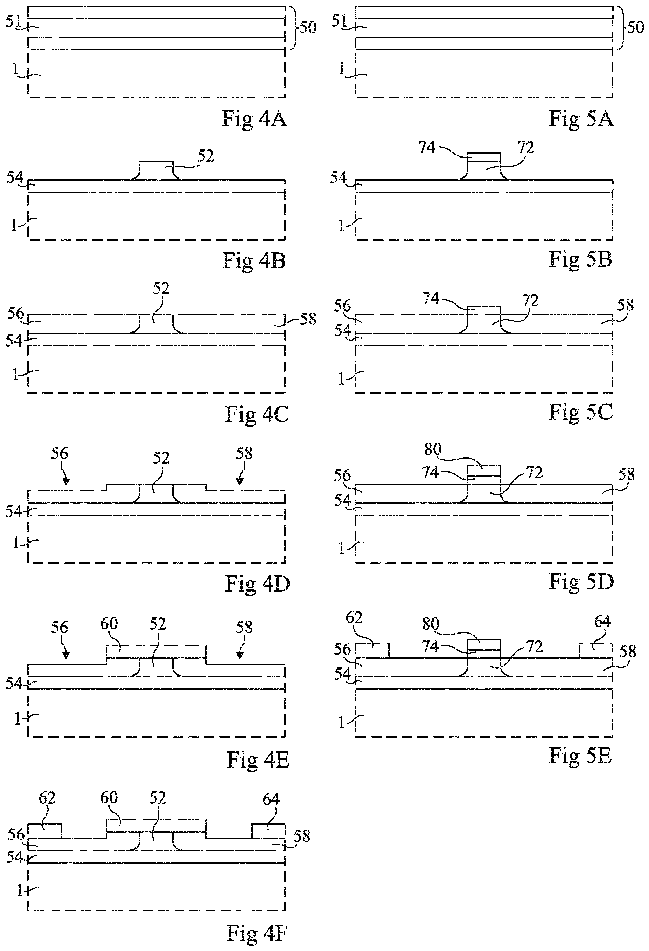

Les figures 4A à 4F sont des vues en coupe transverse illustrant des étapes successives de fabrication d'un exemple d'un laser germanium, à injection latérale.

Comme l'illustre la figure 4A, on part d'un substrat 1 de silicium, éventuellement de type SOI, revêtu d'une couche de germanium 50. Cette couche de germanium 50 comprend une zone centrale 51 fortement dopée de type N. Ceci est obtenu par des épitaxies successives ou par implantation.

A l'étape illustrée en figure 4B, on effectue une gravure pour délimiter une bande 52 du germanium fortement dopé reposant sur une couche 54 de germanium plus faiblement dopé. La partie supérieure de germanium faiblement dopée est éliminée.

A l'étape illustrée en figure 4C, on procède à une épitaxie localisée de SiₓGe₁₋ₓ (x étant un nombre inférieur à 1) contraint sur le germanium 54, de part et d'autre de la bande 52. On obtient ainsi des bandes de SiₓGe₁₋ₓ, s'étendant de part et d'autre de la bande centrale 52 de germanium fortement dopée de type N. Ces bandes de SiₓGe₁₋ₓ sont dopées, par exemple par implantation, pour former des bandes de silicium/germanium 56 et 58 dopées respectivement de type P et de type N.

A l'étape illustrée en figure 4D, des parties de chacune des bandes de silicium/germanium 56 et 58 non voisines de la bande de germanium 52 sont gravées de façon à réduire leur épaisseur. La profondeur de gravure est d'environ 1/3 de l'épaisseur des couches de SiGe 56 et 58 (soit 20 à 100 nm, pour des couches de SiGe de 50 à 300 nm). La dimension latérale des couches de SiGe est de 1 à 2 µm. Ainsi la largeur totale du guide est de 1,05-1,3 µm à 2,05-2,3 µm, selon la largeur de la couche de germanium centrale.

A l'étape illustrée en figure 4E, on a formé sur la partie centrale du guide, c'est-à-dire sur la bande de germanium 52 et sur les parties en relief des bandes 56, 58, une couche de SiN contraint 60 pour exalter la déformation au centre de la structure. La couche de SiN est directement en contact avec la couche de germanium, ce qui permet d'avoir un transfert de contrainte optimisé.

Après cela, comme l'illustre la figure 4F, on forme des contacts électriques 62, 64 sur les bandes de SiGe 56, 58.

Les figures 5A à 5E sont des vues en coupe transverse illustrant des étapes successives de fabrication d'une deuxième variante d'un exemple d'un laser germanium, à injection latérale.

La figure 5A est identique à la figure 4A.

A l'étape illustrée en figure 5B, on a effectué une gravure pour délimiter une bande 72 du germanium fortement dopé reposant sur une couche 54 de germanium plus faiblement dopé. La partie supérieure de germanium faiblement dopée est maintenue en place et forme une bande 74 sur la bande 72.

A l'étape illustrée en figure 5C, on procède à une épitaxie localisée de SiₓGe₁₋ₓ (x étant un nombre inférieur à 1) contraint sur le germanium 54, de part et d'autre de la bande 72. L'épitaxie est interrompue au niveau de la limite entre les bandes 72 et 74. On obtient ainsi des bandes de SiₓGe₁₋ₓ, s'étendant de part et d'autre de la bande centrale 72 de germanium fortement dopée de type N. Ces bandes de SiₓGe₁₋ₓ sont dopées, par exemple par implantation pour former des bandes de silicium/germanium 56 et 58 dopées respectivement de type P et de type N.

A l'étape illustrée en figure 5D, on a formé sur la partie centrale du guide, c'est-à-dire sur la bande de germanium 74, une couche de SiN contraint 80 pour exalter la déformation au centre de la structure. La couche de SiN est directement en contact avec la couche de germanium, ce qui permet d'avoir un transfert de contrainte optimisé.

Après cela, comme l'illustre la figure 5E, on forme des contacts électriques 62, 64 sur les bandes de SiGe 56, 58.

Les structures des figures 4F et 5E utilisent des bandes épitaxiées latérales 56 et 58 de SiₓGe₁₋ₓ contraintes et dopées autour du guide ou ruban central. Ces bandes épitaxiées permettent de :
1) créer une contrainte locale en tension contre le ruban de germanium dans la zone dopée de type N,
2) réaliser l'injection électrique des porteurs dans le germanium dopé N, en profitant des discontinuités des bandes d'énergie entre le Ge et le SiGe pour le confinement des porteurs.

La contrainte en tension de la couche de SiGe va se transférer en tirant latéralement la couche de germanium. La contrainte dépend de la concentration en silicium dans la couche de SiₓGe₁₋ₓ. Elle est due à la différence de paramètre de maille entre le silicium et le germanium.

En ce qui concerne le transfert de contrainte, le paramètre critique est l'épaisseur de la couche de SiₓGe₁₋ₓ qu'il est possible d'épitaxier en fonction de sa composition. La contrainte obtenue dans la couche de SiₓGe₁₋ₓ est proportionnelle au produit de la composition par la différence relative du paramètre de maille entre le silicium et le germanium. Plus la concentration en silicium est importante, plus la couche de SiₓGe₁₋ₓ sera contrainte. Mais en contrepartie, l'épaisseur maximale qu'il est possible d'obtenir diminue. Typiquement les épaisseurs critiques, emax, et les contraintes en déformation bi-axiales, ε//, des couches de SiₓGe₁₋ₓ sont :
- Si_{0,4}Ge_{0,6} : emax=50-70 nm, ε//=1,6 %
- Si_{0,3}Ge_{0,7} : emax=100-150 nm, ε//=1,2 %
- Si_{0,2}Ge_{0,8} : emax=250-300 nm, ε//=0,8 %

L'épaisseur de la zone active de germanium doit être identique à celle de la couche de SiₓGe₁₋ₓ pour un transfert de contrainte optimal. Les demandeurs ont étudié le transfert de contrainte pour ces trois cas et ont également considéré l'effet de l'ajout d'une couche de SiN contraint pour l'amplification de la contrainte transférée.

**Si_{0,2}Ge_{0,8}**

On considère une zone active de germanium de 250x250 nm. La contrainte initiale dans la couche de Si_{0,2}Ge_{0,8} est de ε//=0,8 %. La déformation uniaxiale moyenne dans la zone active de germanium est de 0,5 %, l'ajout d'une couche de SiN permet d'amplifier la déformation uniaxiale moyenne dans le germanium jusqu'à une valeur de 0,6 %.

**Si_{0,3}Ge_{0,7}**

On considère une zone active de germanium de 125x125 nm. La contrainte initiale dans la couche de Si_{0,3}Ge_{0,7} est de ε//=1,2 %. La déformation uniaxiale moyenne dans la zone active de germanium est de 0,9 %, en utilisant des couches de Si_{0,3}Ge_{0,7}. L'ajout d'une couche de SiN permet d'augmenter la déformation uniaxiale moyenne jusqu'à 0,98 %.

**Si_{0,4}Ge_{0,6}**

On considère une zone active de germanium de 50x50 nm. La contrainte uniaxiale moyenne dans la zone active de germanium dans la couche de Si_{0,4}Ge_{0,6} est de ε//=1,6 %. La déformation uniaxiale moyenne dans la zone active de germanium est de 1,13 %, en utilisant des couches de Si_{0,4}Ge_{0,6}. L'ajout d'une couche de SiN permet d'obtenir une déformation uniaxiale moyenne de 1,42 %.

## Revendications

1. Procédé de formation d'un guide d'onde germanium comprenant les étapes suivantes :
prévoir un substrat (1) de silicium de type P revêtu d'une couche de germanium (3) fortement dopée du type N et d'une première couche de silicium (5) dopée de type N ;
former des tranchées (7) pénétrant dans le substrat pour former en superposition une bande de substrat, une bande de germanium et une première bande de silicium (5) ; et
revêtir l'ensemble de la structure d'une couche de nitrure de silicium (9).

2. Procédé selon la revendication 1, comprenant l'étape consistant à définir dans le nitrure de silicium des ouvertures de contact (11) sur les côtés de la première bande de silicium (5) recouvrant la bande de germanium (3).

3. Procédé selon la revendication 2, comprenant l'étape consistant à former des contacts (13) dans lesdites ouvertures.

4. Procédé selon l'une quelconque des revendications 1 à 3, comprenant, après la formation des tranchées (7) et le revêtement de germanium et de silicium, une étape consistant à élargir les ouvertures dans le substrat de sorte que la bande de germanium (3) repose sur un pied de silicium (22).

5. Guide d'onde germanium comprenant une bande de substrat (1) de silicium de type P délimitée par des tranchées latérales (7) pénétrant dans le substrat revêtue d'une bande de germanium (3) fortement dopée de type N et d'une première bande de silicium (5) dopée de type N, l'ensemble étant revêtu d'une couche de nitrure de silicium.

6. Guide d'onde germanium selon la revendication 5, dans lequel les tranchées latérales (7) sont élargies dans leur partie pénétrant dans le substrat de silicium (1), la bande de germanium (3) reposant sur la bande de substrat de silicium (1) qui est de largeur inférieure à la largeur de la bande de germanium (3) .

## Patentansprüche

1. Verfahren zum Ausbilden eines Germanium-Wellenleiters mit den folgenden Schritten:
Vorsehen eines P-Typ-Siliziumsubstrats (1), das mit einer stark dotierten N-Typ Germaniumschicht (3) und mit einer ersten N-Typ-dotierten Siliziumschicht (5) beschichtet ist;
Ausbilden von Gräben (7), die in das Substrat eindringen, um einen Stapel aus einem Substratstreifen, einem Germaniumstreifen und einem ersten Siliziumstreifen (5) zu bilden; und
Beschichten der gesamten Struktur mit einer Siliziumnitrid-Schicht (9).

2. Verfahren nach Anspruch 1, wobei das Verfahren den Schritt des Definierens von Kontaktöffnungen (11) in dem Siliziumnitrid aufweist, und zwar an den Seiten des ersten Siliziumstreifens (5), der den Germaniumstreifen (3) abdeckt.

3. Verfahren nach Anspruch 2, wobei das Verfahren den Schritt des Ausbildens von Kontakten (13) in den Öffnungen aufweist.

4. Verfahren nach einem der Ansprüche 1 bis 3, wobei das Verfahren nach dem Ausbilden der Gräben (7) und der Beschichtung des Germanium und Silizium, einen Schritt der Erweiterung der Öffnungen im Substrat aufweist, so dass der Germaniumstreifen (3) auf einer Siliziumbasis (22) aufliegt.

5. Germanium-Wellenleiter aufweisend einen Streifen eines P-Typ Siliziumsubstrat (1), der durch seitliche Gräben (7) begrenzt ist, die sich in das Substrat erstrecken, welches mit einem stark dotierten N-Typ Germaniumstreifen (3) und mit einem ersten N-Typ dotierten Siliziumstreifen (5) beschichtet ist, wobei die Anordnung mit einer Siliziumnitrid-Schicht beschichtet ist.

6. Germanium-Wellenleiter nach Anspruch 5, wobei die seitlichen Gräben (7) in ihrem in das Siliziumsubstrat (1) erstreckenden Teil verbreitert sind, wobei der Germaniumstreifen (3) auf dem Siliziumsubstratstreifen (1) aufliegt, der eine Breite aufweist, die kleiner ist als die Breite des Germaniumstreifens (3).

## Claims

1. A method of forming a germanium waveguide comprising the steps of:
providing a P-type silicon substrate (1) coated with a heavily-doped N-type germanium layer (3) and with a first N-type doped silicon layer (5);
forming trenches (7) penetrating into the substrate to form a stacking of a substrate strip, a germanium strip, and a first silicon strip (5); and
coating the entire structure with a silicon nitride layer (9).

2. The method of claim 1, comprising the step of defining in the silicon nitride contact openings (11) on the sides of the first silicon strip (5) covering the germanium strip (3).

3. The method of claim 2, comprising the step of forming contacts (13) in said openings.

4. The method of any of claims 1 to 3, comprising, after the forming of the trenches (7) and the coating with germanium and silicon, a step of widening the openings in the substrate so that the germanium strip (3) rests on a silicon base (22).

5. A germanium waveguide comprising a P-type silicon substrate (1) delimited by lateral trenches (7) penetrating into the substrate coated with a heavily-doped N-type germanium strip (3) and with a first N-type doped silicon strip (5), the assembly being coated with a silicon nitride layer.

6. The germanium waveguide of claim 5, wherein the lateral trenches (7) are widened in their portion penetrating into the silicon substrate (1), the germanium strip (3) resting on the silicon substrate strip (1), which has a width smaller than the width of the germanium strip (3).
